(19) Europäisches Patentamt
European Patent Office
Office européen des brevets

(11) **EP 1 281 420 B1**

(12) **EUROPÄISCHE PATENTSCHRIFT**

(45) Veröffentlichungstag und Bekanntmachung des Hinweises auf die Patenterteilung:
**07.09.2005 Patentblatt 2005/36**

(51) Int Cl.$^7$: **B01D 9/00**

(21) Anmeldenummer: **02014491.1**

(22) Anmeldetag: **29.06.2002**

(54) **Kristallisationsverfahren mit Hilfe von Ultraschall**

Crystallisation process using ultrasound

Processus de crystallisation faisant appel aux ultrasons

(84) Benannte Vertragsstaaten:
**AT BE CH CY DE DK ES FI FR GB GR IE IT LI LU MC NL PT SE TR**
Benannte Erstreckungsstaaten:
**RO SI**

(30) Priorität: **30.07.2001 DE 10137017**

(43) Veröffentlichungstag der Anmeldung:
**05.02.2003 Patentblatt 2003/06**

(73) Patentinhaber: **BASF Aktiengesellschaft 67056 Ludwigshafen (DE)**

(72) Erfinder:
- **Rauls, Matthias, Dr.**
  **67117 Limburgerhof (DE)**
- **van Gelder, Richard, Dr.**
  **67346 Speyer (DE)**
- **Wagner, Katrin, Dr.**
  **68163 Mannheim (DE)**
- **Bernard, Harald, Dr.**
  **67157 Wachenheim (DE)**

(56) Entgegenhaltungen:
**WO-A-00/38811**      **US-B1- 6 221 398**

**Beschreibung**

Die vorliegende Erfindung betrifft ein Verfahren zur Kristallisation ein Wirkstoff, der aus der Gruppe der Retinoide ausgewäht ist. Das Verfahren führt zur kristallisation kleiner Partikel mit einer engen Partikelgrößenverteilung. Die erfindungsgemäßen Kristalle werden erhalten, durch Einbringen von Ultraschall in eine Lösung oder Suspension des zu kristallisierenden Stoffes bei gleichzeitiger Einstellung einer bestimmten spezifischen Rührleistung.

Bei vielen Anwendungen, insbesondere bei der Herstellung von Wirkstoffen ist es von Interesse eine genau definierte geringe Partikelgröße bei gleichzeitig enger Partikelgrößenverteilung zu erzielen, da so zum einen oft eine bessere Verarbeitung gewährleistet und beispielsweise bei Wirkstoffen zum anderen so eine bessere Bioverfügbarkeit erzielt werden kann.

Die Einstellung einer gewünschten Partikelgröße auf einen definierten Wert bei einer gleichzeitig engen Partikelgrößenverteilung ist für verschiedene Produkte nicht unproblematisch.

Es ist bekannt, dass sich die Eigenschaften von Kristallen durch Ultraschall modifizieren lassen. Dabei können sowohl Größe als auch Form der Kristalle beeinflusst werden. Aus der Literatur ist darüber hinaus bekannt, dass sich durch Ultraschall-Kristallisation gleichmäßigere Kristalle mit einer engeren Partikelgrößenverteilung erzielen lassen (u.a. T.J. Mason, Chemistry with Ultrasound, Critical Reports on Applied Chemistry, 28, 1990; T.J. Mason, J.P. Lorimer, Sonochemistry: Theory, Applications and Uses of Ultrasound in Chemistry, Ellis Horwood Ltd., Chichester, 1988).

In WO 00/32597 (Smithkline Beecham PLC) werden die Vorteile der Verwendung von Ultraschall für die Kristallisation eines Paroxetin Hydrochlorid Propan-2-ol Solvates beschrieben. Die Beschallung wird hier bevorzugt bei langsamer Abkühlung innerhalb der metastabilen Zone durchgeführt und bei weiterer Abkühlung beibehalten. Dabei entsteht ein leicht rühr-, wasch- und filtrierbares Produkt, das sich zudem besser auflöst als herkömmlich kristallisiertes Produkt.

In EP 0797562 B1 (DuPont) werden ähnliche Auswirkungen von Ultraschall für die Kristallisation von Adipinsäure beschrieben. Die mittlere Partikelgröße wird durch Ultraschall geringfügig reduziert (von 330 auf 300 $\mu$m, d.h. Reduzierung um < 10 %) oder nimmt sogar zu (von 207 auf 215 $\mu$m, d.h. Zunahme um ca. 4 %).

In der WO 00/38811 ist ein Verfahren zur Herstellung kristalliner Partikel durch Fällung der kristallinen Partikel mit einem Nicht-Lösemittel in einer Mischkammer in Gegenwart von Ultraschall beschrieben, wobei mit Hilfe eines Rührers für eine Durchmischung der Ströme von Nicht-Lösemittel und Lösung der zu fällenden Substanz gesorgt wird. Einen wesentlichen Einfluss auf die Partikelbildung haben dabei die Schallintensität und die Flussrate des Nicht-Lösemittels.

Ultraschall lässt sich auf verschiedene Art und Weise in einen Reaktor eintragen. Man unterscheidet dabei zwischen einer direkten Eintragung des Schalls durch Eintauchen einer schwingenden Masse in das Medium und der Ankopplung an Behälterwände gegebenenfalls unter Verwendung einer Kopplungsflüssigkeit. Es existieren drei Grundtypen von Schallgebern: Sonotroden, Flächenwandler (z.B. Ultraschall-Bäder) und Durchflusszellen. Auch der Einsatz von Ultraschall in einem Bypass des eigentlichen Reaktors ist denkbar.

Die Wirkung von Ultraschall bei der Kristallisation entsteht durch Kollisionsvorgänge in der Suspension, die sowohl eine Mikro- als auch eine Makroströmung bewirken, durch Schockwellen (Energieübertragung) sowie durch Schervorgänge. Erforderlich sind daher in der Regel Schallgeber, die viel Energie in das System einbringen und die gleichzeitig große Amplituden, d.h. eine hohe Intensität, aufweisen (z.B. Sonotroden). Wird Ultraschall nur zu Animpf-Zwecken für die Kristallisation eingesetzt, sind i.d.R. auch Schallgeber mit geringer Intensität anwendbar.

Aufgrund von durch Kavitation induzierten Strömungen tendieren Feststoffe in heterogenen Systemen dazu, sich aus Zonen hoher Ultraschall-Intensität herauszubewegen. Für heterogene Systeme sind daher üblicherweise Einbauten erforderlich, die die Feststoffe in Zonen hoher Schallintensität halten. Durchflusszellen haben sich für die Beschallung von Suspensionen bewährt. Sonotroden erzeugen ein Schallfeld, das nur in direkter Nähe des Schallgebers hohe Intensitäten aufweist. In großen Rührkesseln entstehen hierdurch teilweise große Bereiche mit nur geringen Schalldrücken sowie unbeschallte Bereichen, und eine gleichmäßige Beschallung von Feststoffen in Suspensionen ist nur schwer möglich. Ein Scale-up von Ultraschall-Reaktoren, in denen der Ultraschall über Sonotroden eingetragen wird, ist aufgrund der unterschiedlichen Schallfelder in Rührkesseln verschiedener Größe schwierig. Häufig beschränken sich technische Anwendungen von Ultraschall zur Kristallisation daher auf kleine Rührkessel im Labormaßstab (siehe z.B. WO 00/32597, Smithkline Beecham PLC, oder EP 0797562 B1, DuPont - bei beiden Patenten beziehen sich die angegebenen Beispiele offensichtlich auf 1-1-Kristallisatoren) oder auf Durchflusszellen, die im Bypass betrieben werden (z.B. EP 0449008 B1, UK Atomic Energy Authority/Harwell Laboratory). Nachteilig ist hierbei jedoch der unkontrollierte Abrieb von Partikeln in der zur Umwälzung erforderlichen Pumpe.

Aufgabe der Erfindung war die Herstellung von Kristallen, die eine geringe Partikelgröße ($d_{0.5}$ < 100 $\mu$m; $d_{0.1}$ > 45 $\mu$m; $d_{0.9}$ < 295 $\mu$m) bei gleichzeitig enger Partikelgrößenverteilung aufweisen, die sich leicht filtrieren und granulieren lassen und die im Falle von Wirkstoffen darüber hinaus eine gute Bioverfügbarkeit aufweisen.

Erfindungsgemäß gelöst wurde die Aufgabe durch ein Verfahren zur Kristallisation von Kristallen einer mittleren Partikelgröße < 100 $\mu$m, dadurch gekennzeichnet, dass es sich bei der zu kristallisierenden Verbindung um einen Wirkstoff ausgewählt aus der Gruppe der Retinoide handelt, die Konzentration des Wirkstoffes im Kristallisator 1 bis 20 Gew.-% beträgt, dass die Kristallisation bei gleichzeitiger Verwendung von Ultraschall, der über eine Sonotrode direkt in die Lösung oder Suspension der zu kristallisierenden Verbindung eingebracht wird, wobei die Ultraschallfrequenz zwischen 16 und 100 kHz und die Ultraschallintensität bis zu 4 W cm$^{-2}$ liegt, und bei einer spezifischen Rührleistung $P_R$ zwischen 0,2 bis 2 Wkg$^{-1}$ stattfindet, wobei die spezifische Rührleistung folgendermaßen definiert ist:

$$\frac{P_R}{m_{Lsg}} = \frac{Ned^5n^3\rho_{Lsg}}{m_{Lsg}} = \frac{Ned^5n^3}{V_{Lsg}}$$

mit

$m_{Lsg} =$     Masse der eingesetzten Lösung
$Ne =$     $f\,(Re)$ = Leistungsbeiwert des Rührers
$d =$     Rührdurchmesser
$n =$     Rührerdrehzahl
$V_{Lsg} =$     Volumen der eingesetzten Lösung

und der Feststoffgehalt im Kristallisator zwischen 0 und 30 Gew.-% liegt.

Die Erfindung besteht in der Bereitstellung eines Verfahrens zur Kristallisation von Retinsäuren unter Verwendung von Ultraschall, der über eine Sonotrode direkt in die Lösung/Suspension eingebracht wird. Dabei kann ein vorhandener Rührkessel genutzt werden. Anders als die im bisherigen Stand der Technik beschriebenen Systeme eignet sich das hier verwendete System nicht nur für Kristallisationen im Labormaßstab (1 bis 3 l), sondern auch für Rührkessel im Technikums- oder Betriebsmaßstab (> 30 l). Durch die direkte Beschallung der Suspension im Rührkessel wird ein unkontrollierter Abrieb des Feststoffes in einer Pumpe im Umwälzkreislauf vermieden. Eine geeignete Stromführung durch Stromstörer, Leitbleche und/oder geeignete Rührerformen sorgt dafür, dass die Feststoffpartikel ausreichend schnell zu den Bereichen hoher Ultraschallintensität transportiert werden und dort lange genug verweilen. Verwendet werden Ultraschall-Sonotroden mit einer Frequenz von 16 bis 100 kHz und, je nach Größe des Rührkessels, mit einer Leistung von 250 bis 4000 W. Die Amplitude der Sonotrode ist in weiten Bereichen regelbar.

Die Größe der erzeugten Partikel sowie die Breite der Partikelgrößenverteilung lassen sich mit dem neuen Verfahren in weiten Grenzen über die Ultraschallintensität, Dauer und Zeitpunkt der Beschallung und über die eingetragene Rührleistung einstellen. Überraschender Weise wird die Partikelgröße der mit Hilfe von Ultraschall erzeugten Kristalle anders als bei herkömmlichen Kristallisationsverfahren durch Einbringen einer geringeren spezifischen Rührleistung verringert. Die spezifische Rührleistung $P_R$ ist dabei folgendermaßen definiert:

$$\frac{P_R}{m_{Lsg}} = \frac{Ned^5n^3\rho_{Lsg}}{m_{Lsg}} = \frac{Ned^5n^3}{V_{Lsg}} \tag{1}$$

mit

$m_{Lsg} =$     Masse der eingesetzten Lösung
$Ne = f$     $(Re)$ = Leistungsbeiwert des Rührers
$d =$     Rührdurchmesser
$n =$     Rührerdrehzahl
$V_{Lsg} =$     Volumen der eingesetzten Lösung

Eine zu starke Reduktion der spezifischen Rührleistung führt jedoch zu einer unzureichenden Suspendierung der Partikel, die dadurch u. a. nicht mehr häufig genug in die Zonen hoher Ultraschallintensität gelangen.

Durch den Ultraschall werden sowohl die Kristallgröße als auch ihre Form verändert (Produktion von gleichförmigen, nahezu runden Partikel anstelle von großen Nadeln und bruchstückartigem Feinanteil). Mit Hilfe eines Röntgendiffraktogramms wurde nachgewiesen, dass sich die Modifikation z.B. bei der 13-(Z)-Retinsäure durch die Beschallung nicht ändert (Kupferstrahlung bei 25°C: Haupt-Peaks etwa bei 10,4/15,9/16,4/18/20,2/21,8/24,8/26,8 Å).

Unter den Retinoiden versteht man beispielsweise Retinol, Retinal, 9-(Z)-Retinsäure, 13-(Z)-Retinsäure (Isotretinoin) oder all(E)-Retinsäure (Tretinoin). Insbesondere bevorzugt eignet sich das Verfahren aber zur Kristallisation von 13-(Z)-Retinsäure.

Die erfindungsgemäße Kristallisation wird in Lösung bzw. Suspension des zu kristallisierenden Stoffes durchgeführt. Dabei beträgt die Konzentration des zu kristallisierenden Stoffes zwischen 1 und 20 Gew.-%, bevorzugt zwischen 4 und 17 Gew.-%.

Als Lösungsmittel werden für den jeweiligen Stoff sowie für den Ultraschall-Einsatz geeignete Lösungsmittel eingesetzt.

Für Retinoide geeignete Lösungsmittel sind niedermolekulare n- bzw. iso-Alkohole von Methanol, Ethanol, Propanol, Butanol, Pentanol oder Hexanol, insbesondere bevorzugt verwendet man 2-Propanol.

Die Kristallisation kann in jedem beliebigen Kristallisator durchgeführt werde, beispielsweise in einem Rührkessel oder einem Leitrohrkristallisator. Die Temperatur im Kristallisator beträgt zwischen -10 und 120°C, bevorzugt zwischen 0 und 80°C.

Die Kristallisation kann sowohl als Kühlungskristallisation mit konstanter Abkühlrate oder als Abkühlungsprogramm mit unterschiedlichen Abkühlraten durchgeführt werden.

Die Partikelgröße der Kristalle ist <100 µm, bevorzugt liegt sie zwischen 30 und 90 µm.

Ebenso kann die Dauer des Ultraschalleinsatzes variiert werden. Es kann während des gesamten Kristallisationsprozesses Ultraschall eingesetzt werden oder nur während der Keimbildungsphase oder erst nach Erreichen einer möglichst hohen Übersättigung.

Die Frequenz des Ultraschalls beträgt zwischen 16 bis 100 kHz bei einer Intensität bis zu 4 W cm$^{-2}$.

Die spezifische Rührleistung $P_R$ liegt zwischen 0,2 bis 2 W kg$^{-1}$, bevorzugt zwischen 0,3 bis 1 W kg$^{-1}$.

Der Feststoffgehalt im Kristallisator liegt zwischen 0 und 30 Gew.-%, bevorzugt zwischen 5 und 20 Gew.-%.

Handelt es sich bei den durch das erfindungsgemäße Verfahren hergestellten Partikeln um Wirkstoffe, so werden diese zusammen mit üblichen Hilfsstoffen zur Herstellung von pharmazeutischen oder kosmetischen Darreichungsformen verwendet oder als Zusätze in Nahrungs- oder Tierfuttermitteln.

Das in den Ausführungsbeispielen aufgeführte Isotretinoin wird beispielsweise zur oralen Behandlung von Hauterkrankungen (Akne) eingesetzt.

Das erfindungsgemäße Kristallisationsverfahren weist die folgenden Vorteile auf:

- Ein zusätzlicher Verfahrensschritt zur Einstellung der gewünschten geringen Partikelgröße wird vermieden.
- Neben einer geringeren Partikelgröße und einer engeren Partikelgrößenverteilung als bei herkömmlichen Kristallisationsverfahren weist das erzeugte Produkt eine bessere Rieselfähigkeit und eine höhere Bioverfügbarkeit auf.
- Es sind keine Zusatzstoffe im Kristallisationsprozess erforderlich, um die Kristallform und -größe zu beeinflussen.
- Die Reinheit der erzeugten Produkte ist höher als bei bisherigen konventionellen Kühlungskristallisationsverfahren.
- Die Partikelgrößenverteilung lässt sich außer über das Temperaturprogramm beim Abkühlen auch über die Parameter Ultraschallintensität, spezifische Rührleistung und Ultraschalldauer gezielt beeinflussen.
- Die Reproduzierbarkeit der Partikelgrößenverteilung ist höher als bei konventionellen Kristallisationsverfahren.
- Die Umrüstung vorhandener Kristallisatoren ist problemlos möglich.

Die folgenden Beispiele sollen die Erfindung näher erläutern, ohne sie jedoch darauf einzuschränken:

Beispiel 1: Kristallisation mit und ohne Ultraschall

Eine Lösung mit 15,4 Gew.-% Isotretinoin in 2-Propanol wird in einem 3-1-Rührkessel mit einer spezifischen Rührleistung von 0,5 W kg$^{-1}$ gerührt und ausgehend von einer Anfangstemperatur von 72°C mit einer Abkühlgeschwindigkeit von 3 K h$^{-1}$ bis auf 50°C und weiter mit 10 K h$^{-1}$ bis auf 0°C abgekühlt (Probe 1). Bei Probe 2 wird während des gesamten Prozesses Ultraschall über eine 250 W-Sonotrode mit einer Frequenz von 20 kHz eingetragen. In beiden Fällen wird die Lösung anschließend bei 0°C für eine Stunde ohne Ultraschall nachgerührt. Die jeweils resultierende mittlere Partikelgröße $d_{0,5}$ (volumenbezogen) und die Steilheit der Verteilung (Spanne S) entsprechend

$$S = \frac{d_{0,9} - d_{0,1}}{d_{0,5}} \qquad (2)$$

sind in Tabelle 1 angegeben.

Tabelle 1:

| Partikelgröße und Spanne für die Kristallisation von Isotre-tinoin mit und ohne Ultraschall | | | |
|---|---|---|---|
| Proben-Nr. | Beschreibung | $d_{0,5}$ / µm | S |
| 1 | ohne US | 227,2 | 2,20 |
| 2 | mit US | 57,9 | 1,13 |

Beispiel 2: Variation der spezifischen Rührleistung

Eine Lösung von Isotretinoin in 2-Propanol wird analog zu Beispiel 1 unter Einsatz von Ultraschall kristallisiert. Dabei werden verschiedene Mengen spezifischer Rührleistung $P_R$ zwischen 1,5 W kg$^{-1}$ (Probe 3) und 0,25 W kg$^{-1}$ (Probe 4) eingetragen. Die Ergebnisse sind in Tabelle 2 dargestellt. Bezüglich der spezifischen Rührleistung existiert ein Optimum im Bereich mittlerer Rührleistung (Probe 2), bei dem sowohl die geringste mittlere Partikelgröße als auch eine sehr enge Verteilung erzielt wird.

Tabelle 2:

| Partikelgröße und Spanne für die Ultraschall-Kristallisation von Isotretinoin bei verschiedenen Rührleistungen | | | |
|---|---|---|---|
| Proben-Nr. | $P_R$ / (W kg$^{-1}$) | $d_{0,5}$ / µm | S |
| 3 | 1,5 | 72,0 | 1,44 |
| 2 | 0,5 | 57,9 | 1,13 |
| 4 | 0,25 | 66,2 | 1,65 |

Beispiel 3: Variation von Beschallungszeitpunkt und -dauer

Eine Lösung von Isotretinoin in 2-Propanol wird analog zu Beispiel 1 bei einer spezifischen Rührleistung von 0,5 W kg$^{-1}$ unter Einsatz von Ultraschall kristallisiert. Dabei werden Beschallungszeitpunkt und -dauer variiert. Tabelle 3 zeigen die Ergebnisse für eine Beschallung zu Beginn des Kristallisationsprozesses von der Ausgangstemperatur bis auf 55°C (Probe 5) sowie für eine Beschallung am Ende des Prozesses von 59°C bis auf 0°C (Probe 6). Die Ergebnisse ohne Beschallung sowie für eine Beschallung über den gesamten Kühlungsprozess sind in Beispiel 1 angegeben (Proben 1 und 2). Durch den Einsatz von Ultraschall nur zu Beginn des Kristallisationprozesses (im Bereich der Keimbildung) lässt sich eine genauso enge Partikelgrößenverteilung erzeugen wie mit Ultraschall während des gesamten Prozesses, wobei jedoch gleichzeitig die mittlere Partikelgröße zunimmt.

Tabelle 3:

| Partikelgröße und Spanne für eine Kristallisation von Isotretinoin mit unterschiedlicher Beschallungsdauer | | | |
|---|---|---|---|
| Proben-Nr. | Ultraschalleinsatz | $d_{0,5}$ / µm | S |
| 1 | ohne | 227,2 | 2,20 |
| 5 | bis 55°C | 139,0 | 1,26 |
| 6 | von 59°C bis 0°C | 83,4 | 1,72 |
| 2 | bis 0°C | 57,9 | 1,13 |

Beispiel 4: Variation der Isotretinoin-Ausgangskonzentration (Lösungsmittelverhältnis)

Bei der Kristallisation von Isotretinoin mit Ultraschall wird das Lösungsmittelverhältnis (Verhältnis 2-Propanol: Isotretinoin) variiert. Eine Lösung mit einer Ausgangskonzentration von 15,4 Gew.-% Isotretinoin in 2-Propanol (Lösungsmittelverhältnis 5,5:1) dient als Vergleichsprobe (Probe 2). Eine Lösung mit 8,3 Gew.-% Isotretinoin in 2-Propanol (Lösungsmittelverhältnis 11:1) wird unter den in Beispiel 1 genannten Bedingungen (3-1-Kristallisator, spez. Rührleistung: 0,5 W kg$^{-1}$, Abkühlprogramm, Ultraschall: 250 W während der gesamten Abkühlphase, Nachrührphase) kristallisiert (Probe 7). Die Ergebnisse sind in Tabelle 4 dargestellt. Eine Änderung des Lösungsmittelverhältnisses bei der Ultraschallkristallisation von Isotretinoin wirkt sich demnach nicht signifikant auf die mittlere Partikelgröße oder die Breite der Partikelgrößenverteilung aus.

Tabelle 4:

| Partikelgröße und Spanne für eine Ultraschall-Kristallisation von Isotretinoin mit unterschiedlichen Lösungsmittelverhältnissen | | | | |
|---|---|---|---|---|
| Proben-Nr. | $w_{Isotretinoin}$ /Gew.-% | Lösungsmittelverhältnis | $d_{0,5}$ / µm | S |
| 2 | 15,4 | 5,5:1 | 57,9 | 1,13 |
| 7 | 8,3 | 11:1 | 62,6 | 1,26 |

**Patentansprüche**

1. Verfahren zur Kristallisation von Kristallen einer mittleren Partikelgröße < 100 µm, **dadurch gekennzeichnet, dass** es sich bei der zu kristallisierenden Verbindung um einen Wirkstoff ausgewählt aus der Gruppe der Retinoide handelt, die Konzentration des Wirkstoffes im Kristallisator 1 bis 20 Gew.-% beträgt, dass die Kristallisation bei gleichzeitiger Verwendung von Ultraschall, der über eine Sonotrode direkt in die Lösung oder Suspension der zu kristallisierenden Verbindung eingebracht wird, wobei die Ultraschallfrequenz zwischen 16 und 100 kHz und die Ultraschallintensität bis zu 4 W cm$^{-2}$ liegt, und bei einer spezifischen Rührleistung $P_R$ zwischen 0,2 bis 2 Wkg$^{-1}$ stattfindet, wobei die spezifische Rührleistung folgendermaßen definiert ist:

$$\frac{P_R}{m_{Lsg}} = \frac{Ned^5 n^3 \rho_{Lsg}}{m_{Lsg}} = \frac{Ned^5 n^3}{V_{Lsg}}$$

mit

$m_{Lsg}$ = Masse der eingesetzten Lösung
$Ne = f\,(Re)$ = Leistungsbeiwert des Rührers
$d$ = Rührdurchmesser
$n$ = Rührerdrehzahl
$V_{Lsg}$ = Volumen der eingesetzten Lösung

und der Feststoffgehalt im Kristallisator zwischen 0 und 30 Gew.-% liegt.

2. Verfahren gemäß Anspruch 1, **dadurch gekennzeichnet, dass** es sich bei dem Wirkstoff um 13-(Z)-Retinsäure handelt.

3. Verfahren gemäß einem der Ansprüche 1 oder 2, **dadurch gekennzeichnet, dass** die Kristallisation in einem Rührkessel oder Leitrohrkristallisator stattfindet.

4. Verfahren gemäß einem der Ansprüche 1 bis 3, **dadurch gekennzeichnet, dass** die Temperatur im Kristallisator zwischen -10 und 120°C beträgt.

5. Verfahren gemäß einem der Ansprüche 1 bis 4, **dadurch gekennzeichnet, dass** die Kristallisation als Kühlungskristallisation mit konstanter Abkühlrate oder als Abkühlprogramm mit unterschiedlichen Abkühlraten stattfindet.

6. Verfahren gemäß einem der Ansprüche 1 bis 5, **dadurch gekennzeichnet, dass** während des gesamten Kristallisationsprozesses Ultraschall verwendet wird.

7. Verfahren gemäß einem der Ansprüche 1 bis 5, **dadurch gekennzeichnet, dass** nur während der Keimbildungsphase Ultraschall eingesetzt wird.


**Claims**

1. A process for crystallizing crystals with an average particle size of <100 µm, wherein the compound to be crystallized is an active substance selected from the group of retinoids, the concentration of the active substance in the crystalliser is from 1 to 20% by weight, wherein the crystallization takes place with simultaneous use of ultrasound which is introduced by a sonotrode directly into the solution or suspension of the compound to be crystallized, where the ultrasonic intensity is between 16 and 100 kHz and the ultrasonic intensity is up to 4 W cm$^{-2}$, and takes place with a specific stirring power $P_R$ of between 0.2 to 2 Wkg$^{-1}$, where the specific stirring power is defined as follows

$$\frac{P_R}{m_{sol}} = \frac{Ned^5 n^3 \rho_{sol}}{m_{sol}} = \frac{Ned^5 n^3}{V_{sol}} \qquad (1)$$

with

$m_{sol}$ = mass of the solution employed
$Ne$ = $f(Re)$ = power factor of the stirrer
$d$ = stirrer diameter
$n$ = speed of stirrer rotation
$V_{sol}$ = volume of the solution employed

and the solids content in the crystallizer is between 0 and 30% by weight.

2. A process as claimed in claim 1, wherein the active substance is 13-(Z)-retinoic acid.

3. A process as claimed in claim 1 or 2, wherein the crystallization takes place in a stirred vessel or draft tube crystallizer.

4. A process as claimed in any of claims 1 to 3, wherein the temperature in the crystallizer is between -10 and 120°C.

5. A process as claimed in any of claims 1 to 4, wherein the crystallization takes place as cooling crystallization with a constant cooling rate or as cooling program with different cooling rates.

6. A process as claimed in any of claims 1 to 5, wherein ultrasound is used throughout the crystallization process.

7. A process as claimed in any of claims 1 to 5, wherein ultrasound is employed only during the nucleation phase.

**Revendications**

1. Procédé de cristallisation de cristaux présentant une taille de particule moyenne <100 µm, **caractérisé en ce que**, pour ce qui concerne le composé à cristalliser, il s'agit d'une substance active choisie parmi le groupe des rétinoïdes, la concentration de la substance active dans le cristallisoir étant de 1 à 20% en poids, et **en ce que** la cristallisation a lieu lors d'une utilisation simultanée d'ultrasons qui sont introduits directement dans la solution ou suspension du composé à cristalliser par l'intermédiaire d'une sonotrode, la fréquence des ultrasons étant comprise entre 16 et 100 kHz et l'intensité des ultrasons allant jusqu'à 4 W cm$^{-2}$, et lors d'une puissance d'agitation spécifique $P_R$ comprise entre 0,2 et 2 Wkg$^{-1}$, la puissance d'agitation spécifique étant définie de la manière suivante :

$$\frac{P_R}{m_{Lsg}} = \frac{Ned^5 n^3 \rho_{Lsg}}{m_{Lsg}} = \frac{Ned^5 n^3}{V_{Lsg}}$$

où

$m_{Lsg}$ = masse de la solution mise en oeuvre,
$Ne$ = $f(Re)$ = coefficient de puissance de l'agitateur
$d$ = diamètre d'agitation
$n$ = nombre de tours d'agitateur
$V_{Lsg}$ = volume de la solution mise en oeuvre

et la teneur en matière solide dans le cristallisoir étant comprise entre 0 et 30% en poids.

2. Procédé suivant la revendication 1, **caractérisé en ce que**, pour ce qui concerne la substance active, il s'agit d'acide 13-(Z)-rétinique.

3. Procédé suivant l'une des revendications 1 et 2, **caractérisé en ce que** la cristallisation a lieu dans une cuve d'agitation ou un cristallisoir à tube directeur.

4. Procédé suivant l'une des revendications 1 à 3, **caractérisé en ce que** la température dans le cristallisoir est comprise entre -10 et 120°C.

5. Procédé suivant l'une des revendications 1 à 4, **caractérisé en ce que** la cristallisation a lieu sous la forme d'une cristallisation de refroidissement avec une vitesse de refroidissement constante ou sous la forme d'un programme de refroidissement avec différentes vitesses de refroidissement.

6. Procédé suivant l'une des revendications 1 à 5, **caractérisé en ce que**, pendant la totalité du processus de cristallisation, on utilise des ultrasons.

7. Procédé suivant l'une des revendications 1 à 5, **caractérisé en ce qu'**on ne met en oeuvre des ultrasons que pendant la phase de germination.